# EUROPEAN PATENT APPLICATION

(11) **EP 3 648 342 A1**
(43) Date of publication of application: **06.05.2020**
(21) Application number: 17918880.0
(22) Date of filing: 27.07.2017
(51) Int. Cl.: H03D 7/00, H03D 7/14

(54) **HIGH FREQUENCY MIXER**

(71) Applicant: Mitsubishi Electric Corporation, Chiyoda-ku Tokyo 100-8310 (JP)
(72) Inventor: INAGAKI, Ryuji, Tokyo 100-8310 (JP); SOMADA, Ichiro, Tokyo 100-8310 (JP); TSURU, Masaomi, Tokyo 100-8310 (JP); SHIMOZAWA, Mitsuhiro, Tokyo 100-8310 (JP)
(74) Representative: Pfenning, Meinig & Partner mbB
(86) International application number: PCT/JP2017/027272
(87) International publication number: WO 2019/021425

(57) **Abstract**

A first balanced/unbalanced circuit (7) is provided that splits a first mixed wave outputted from an even harmonic mixer (3) into two split signals, outputs a first split signal which is one of the two split signals of the first mixed wave that is in phase with the first mixed wave to a first output terminal (14), and outputs a second split signal which is another one of the two split signals of the first mixed wave that is opposite in phase to the first mixed wave to a second output terminal (15). Further, a second balanced/unbalanced circuit (11) is provided that splits a second mixed wave outputted from the even harmonic mixer (3) into two split signals, outputs a third split signal which is one of the two split signals of the second mixed wave that is in phase with the second mixed wave to the second output terminal (15), and outputs a fourth split signal which is another one of the two split signals of the second mixed wave that is opposite in phase to the second mixed wave to the first output terminal (14).

## Description

### TECHNICAL FIELD

The present invention relates to a radio frequency mixer including an even harmonic mixer that mixes intermediate frequency signals with harmonics having a frequency twice that of local signals.

### BACKGROUND ART

For example, as a component used in a frequency converting unit of a microwave or millimeter-wave band radio device, there is a radio frequency mixer.

To reduce a cost and improve frequency stability, etc., of the radio device, it is required to decrease the frequency of LO waves which are local signals.

Thus, in some cases, an even harmonic mixer is used that generates a mixed wave of a double wave which is a harmonic having a frequency twice that of an LO wave and an IF signal which is an intermediate frequency signal.

When an even harmonic mixer is used in a radio frequency mixer, the frequency of an LO wave can be decreased to one-half compared to a radio frequency mixer that mixes an LO wave with an IF signal.

An even harmonic mixer disclosed in the following Patent Literature 1 includes two unit mixers disposed in parallel to each other, each unit mixer including the following three transistors:
(1) A first NPN transistor having a collector terminal connected to a power supply through an output load;
(2) A second NPN transistor having a collector terminal connected to the collector terminal of the first NPN transistor, and an emitter terminal connected to an emitter terminal of the first NPN transistor; and
(3) A third NPN transistor having a collector terminal connected to the emitter terminals of the first and second NPN transistors, and an emitter terminal connected to a ground.

In this even harmonic mixer, differential LO input terminals to which differential LO waves are inputted are connected to the base terminals of the first and second NPN transistors of each unit mixer, and differential IF input terminals to which differential IF signals are inputted are connected to the base terminals of the third NPN transistors.

Hence, a mixed wave obtained by mixing double waves of the LO waves inputted from the differential LO input terminals with the IF signals inputted from the differential IF input terminals is outputted from the collector terminals of the first and second NPN transistors. By this, the mixed wave is outputted from output terminals connected to the collector terminals of the first and second NPN transistors.

When the frequency of the LO waves is f_{LO} and the frequency of the IF signals is f_{IF}, a mixed wave with a frequency of 2f_{LO} + f_{IF} and a mixed wave with a frequency of 2f_{LO} - f_{IF} are outputted from the output terminals connected to the collector terminals of the first and second NPN transistors.

The mixed wave with a frequency of 2f_{LO} + f_{IF} outputted from the output terminal of one of the unit mixers and the mixed wave with a frequency of 2f_{LO} - f_{IF} outputted from the output terminal of the other unit mixer are reversed in phase relative to each other. Hence, the mixed wave with a frequency of 2f_{LO} + f_{IF} and the mixed wave with a frequency of 2f_{LO} - f_{IF} are differential signals.

In addition, a double wave of an LO wave is outputted as a signal with a frequency of 2f_{LO} from the output terminal of the one of the unit mixers in addition to the mixed wave with a frequency of 2f_{LO} + f_{IF}, and a double wave of an LO wave is outputted from the output terminal of the other one of the unit mixers in addition to the mixed wave with a frequency of 2f_{LO} - f_{IF}.

The double wave of the LO wave outputted from the output terminal of the one of the unit mixers and the double wave of the LO wave outputted from the output terminal of the other one of the unit mixers are in-phase signals.

When, of the mixed wave with a frequency of 2f_{LO} + f_{IF} and the mixed wave with a frequency of 2f_{LO} - f_{IF}, for example, the mixed wave with a frequency of 2f_{LO} + f_{IF} is a desired signal, the mixed wave with a frequency of 2f_{LO} - f_{IF} and the double waves of the LO waves are unwanted waves.

To remove the mixed wave with a frequency of 2f_{LO} - f_{IF} and the double waves of the LO waves, a filter may be provided at a stage subsequent to the even harmonic mixer, but since the double waves of the LO waves are close in frequency to the mixed wave with a frequency of 2f_{LO} + f_{IF} which is the desired signal, removing the double waves of the LO waves requires a filter with steep characteristics.

### CITATION LIST

### PATENT LITERATURES

Patent Literature 1: WO 01/001564 A

### SUMMARY OF INVENTION

### TECHNICAL PROBLEM

The conventional even harmonic mixer can suppress passage loss of the mixed wave with a frequency of 2f_{LO} + f_{IF} which is the desired signal upon removal of the double waves of the LO waves which are unwanted waves, by providing a filter with steep characteristics at a subsequent stage. However, even if a filter with steep characteristics is used, it is difficult to eliminate passage loss of the mixed wave with a frequency of 2f_{LO} + f_{IF} which is the desired signal.

In addition, when the double waves of the LO waves which are unwanted waves are removed, the mixed wave with a frequency of 2f_{LO} - f_{IF} is undesirably removed as an unwanted wave.

Hence, there is a problem that the mixed wave with a frequency of 2f_{LO} + f_{IF} and the mixed wave with a frequency of 2f_{LO} - f_{IF} cannot be outputted as differential signals.

The invention is made to solve a problem such as that described above, and an object of the invention is to obtain a radio frequency mixer capable of outputting differential signals without causing passage loss associated with removal of unwanted waves.

### SOLUTION TO PROBLEM

A radio frequency mixer according to the invention includes: an even harmonic mixer mixing differential intermediate frequency signals with harmonics having a frequency twice a frequency of differential local signals, and outputting a first mixed wave and a second mixed wave, the first mixed wave being a mixed wave of the intermediate frequency signals and the harmonics, and the second mixed wave being a mixed wave opposite in phase to the first mixed wave; a first balanced/unbalanced circuit splitting the first mixed wave outputted from the even harmonic mixer into two split signals, outputting a first split signal to a first output terminal, and outputting a second split signal to a second output terminal, the first split signal being one of the two split signals of the first mixed wave that is in phase with the first mixed wave, and the second split signal being one of the two split signals of the first mixed wave that is opposite in phase to the first mixed wave; and a second balanced/unbalanced circuit splitting the second mixed wave outputted from the even harmonic mixer into two split signals, outputting a third split signal to the second output terminal, and outputting a fourth split signal to the first output terminal, the third split signal being one of the two split signals of the second mixed wave that is in phase with the second mixed wave, and the fourth split signal being one of the two split signals of the second mixed wave that is opposite in phase to the second mixed wave.

### ADVANTAGEOUS EFFECTS OF INVENTION

According to the invention, the radio frequency mixer is configured to include: a first balanced/unbalanced circuit splitting the first mixed wave outputted from the even harmonic mixer into two split signals, outputting a first split signal to a first output terminal, and outputting a second split signal to a second output terminal, the first split signal being one of the two split signals of the first mixed wave that is in phase with the first mixed wave, and the second split signal being one of the two split signals of the first mixed wave that is opposite in phase to the first mixed wave; and a second balanced/unbalanced circuit splitting the second mixed wave outputted from the even harmonic mixer into two split signals, outputting a third split signal to the second output terminal, and outputting a fourth split signal to the first output terminal, the third split signal being one of the two split signals of the second mixed wave that is in phase with the second mixed wave, and the fourth split signal being one of the two split signals of the second mixed wave that is opposite in phase to the second mixed wave. Thus, there is an advantageous effect that differential signals can be outputted without causing passage loss associated with removal of unwanted waves.

### BRIEF DESCRIPTION OF DRAWINGS

FIG. 1 is a configuration diagram showing a radio frequency mixer of a first embodiment of the invention.
FIG. 2 is an illustrative diagram showing a plurality of frequency components included in output signals from an even harmonic mixer 3.
FIG. 3 is a configuration diagram showing a radio frequency mixer of a second embodiment of the invention.
FIG. 4 is a configuration diagram showing a radio frequency mixer of a third embodiment of the invention.
FIG. 5 is a configuration diagram showing a radio frequency mixer of a fourth embodiment of the invention.
FIG. 6 is an illustrative diagram showing an example of a first transformer 41 and a second transformer 44.

### DESCRIPTION OF EMBODIMENTS

To describe the invention in more detail, some embodiments for carrying out the invention will be described below with reference to the accompanying drawings.

### First Embodiment.

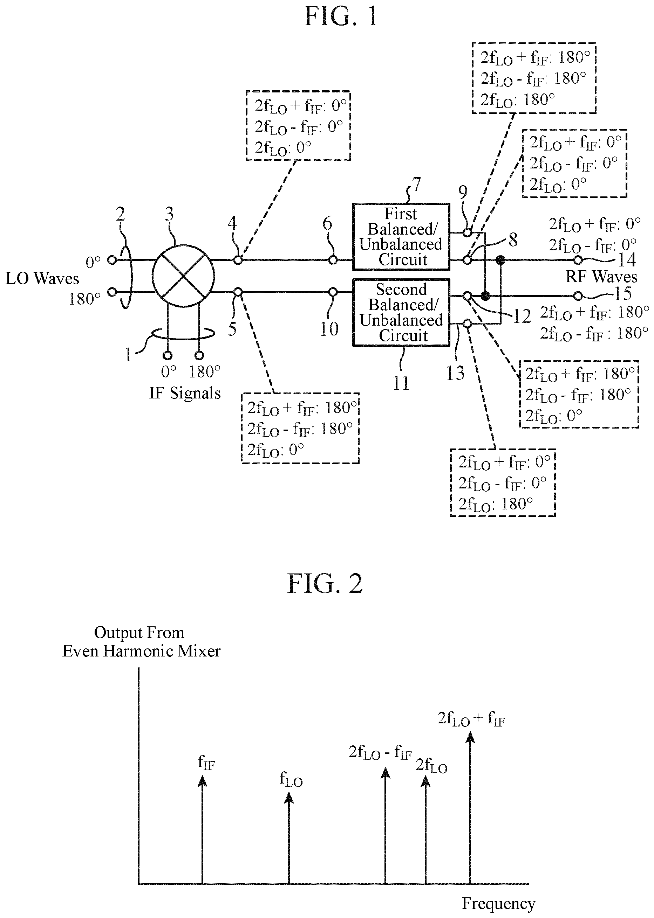

FIG. 1 is a configuration diagram showing a radio frequency mixer of a first embodiment of the invention.

In FIG. 1, differential IF terminals 1 accept, as input, an IF signal with a phase of 0° and an IF signal with a phase of 180° as differential IF signals (intermediate frequency signals).

Differential LO terminals 2 accept, as input, an LO wave with a phase of 0° and an LO wave with a phase of 180° as differential LO waves (local signals).

An even harmonic mixer 3 mixes the differential IF signals inputted from the differential IF terminals 1 with double waves which are harmonics having a frequency twice that of the differential LO waves inputted from the differential LO terminals 2, outputs a first mixed wave which is a mixed wave of the IF signals and the double waves of the LO waves from a positive-phase output terminal 4, and outputs a second mixed wave which is a mixed wave opposite in phase to the first mixed wave from a negative-phase output terminal 5.

The positive-phase output terminal 4 is a positive-phase RF terminal of the even harmonic mixer 3 that outputs the first mixed wave.

The negative-phase output terminal 5 is a negative-phase RF terminal of the even harmonic mixer 3 that outputs the second mixed wave.

A first unbalanced terminal 6 is a terminal of a first balanced/unbalanced circuit 7 that is connected to the positive-phase output terminal 4 of the even harmonic mixer 3.

The first balanced/unbalanced circuit 7 splits the first mixed wave outputted from the positive-phase output terminal 4 of the even harmonic mixer 3 into two split signals.

The first balanced/unbalanced circuit 7 outputs a first split signal which is one of the two split signals of the first mixed wave that is in phase with the first mixed wave to a first output terminal 14, and outputs a second split signal which is a split signal opposite in phase to the first mixed wave to a second output terminal 15.

A first balanced positive-phase terminal 8 is a terminal of the first balanced/unbalanced circuit 7 that is connected to the first output terminal 14.

A first balanced negative-phase terminal 9 is a terminal of the first balanced/unbalanced circuit 7 that is connected to the second output terminal 15.

A second unbalanced terminal 10 is a terminal of a second balanced/unbalanced circuit 11 that is connected to the negative-phase output terminal 5 of the even harmonic mixer 3.

The second balanced/unbalanced circuit 11 splits the second mixed wave outputted from the negative-phase output terminal 5 of the even harmonic mixer 3 into two split signals.

The second balanced/unbalanced circuit 11 outputs a third split signal which is one of the two split signals of the second mixed wave that is in phase with the second mixed wave to the second output terminal 15, and outputs a fourth split signal which is a split signal opposite in phase to the second mixed wave to the first output terminal 14.

A second balanced positive-phase terminal 12 is a terminal of the second balanced/unbalanced circuit 11 that is connected to the second output terminal 15.

A second balanced negative-phase terminal 13 is a terminal of the second balanced/unbalanced circuit 11 that is connected to the first output terminal 14.

The first output terminal 14 is a positive-phase output terminal connected to each of the first balanced positive-phase terminal 8 of the first balanced/unbalanced circuit 7 and the second balanced negative-phase terminal 13 of the second balanced/unbalanced circuit 11.

The second output terminal 15 is a negative-phase output terminal connected to each of the first balanced negative-phase terminal 9 of the first balanced/unbalanced circuit 7 and the second balanced positive-phase terminal 12 of the second balanced/unbalanced circuit 11.

Next, operation will be described.

An IF signal with a phase of 0° and an IF signal with a phase of 180° are inputted as differential IF signals from the differential IF terminals 1, and an LO wave with a phase of 0° and an LO wave with a phase of 180° are inputted as differential LO waves from the differential LO terminals 2.

The even harmonic mixer 3 mixes the differential IF signals inputted from the differential IF terminals 1 with double waves of the differential LO waves inputted from the differential LO terminals 2.

The even harmonic mixer 3 outputs a first mixed wave which is a mixed wave of the IF signals and the double waves of the LO waves from the positive-phase output terminal 4, and outputs a second mixed wave which is a mixed wave opposite in phase to the first mixed wave from the negative-phase output terminal 5.

When the frequency of the LO waves is f_{LO} and the frequency of the IF signals is f_{IF}, a mixed wave with a frequency of 2f_{LO} + f_{IF} and a mixed wave with a frequency of 2f_{LO} - f_{IF} are outputted as a first mixed wave from the positive-phase output terminal 4 of the even harmonic mixer 3.

In addition, a mixed wave with a frequency of 2f_{LO} + f_{IF} and a mixed wave with a frequency of 2f_{LO} - f_{IF} are outputted as a second mixed wave from the negative-phase output terminal 5.

In addition, each of the LO waves and the double waves of the LO waves leaks from the positive-phase output terminal 4 and the negative-phase output terminal 5 of the even harmonic mixer 3.

FIG. 2 is an illustrative diagram showing a plurality of frequency components included in the output signals from the even harmonic mixer 3.

As shown in FIG. 2, the frequency f_{LO} of the LO waves is away from the frequencies of RF waves which are radio frequency signals and thus can be easily cut off by a filter, etc. The frequencies of the RF waves are frequencies such as 2f_{LO} + f_{IF} and 2f_{LO} - f_{IF}.

However, since the frequency 2f_{LO} of the double waves of the LO waves is close to the frequencies of the RF waves, when the frequency 2f_{LO} is cut off using a filter, a filter with steep characteristics needs to be used. However, even if a filter with steep characteristics is used, it is difficult to eliminate, for example, passage loss of the mixed wave with a frequency of 2f_{LO} + f_{IF}.

A relationship between the phases of signals outputted from the positive-phase output terminal 4 and the negative-phase output terminal 5 of the even harmonic mixer 3 is as follows:

| | Positive-phase output terminal 4 | | Negative-phase output terminal 5 | |
|---|---|---|---|---|
| 2f_{LO} + f_{IF} | 0° | | 180° | |
| 2f_{LO} - f_{IF} | | 0° | | 180° |
| 2f_{LO} | 0° | | 0° | |

Therefore, the first mixed wave outputted from the positive-phase output terminal 4 of the even harmonic mixer 3 and the second mixed wave outputted from the negative-phase output terminal 5 of the even harmonic mixer 3 have an opposite-phase relationship.

In addition, a double wave of an LO wave outputted from the positive-phase output terminal 4 of the even harmonic mixer 3 and a double wave of an LO wave outputted from the negative-phase output terminal 5 of the even harmonic mixer 3 have an in-phase relationship.

Although here, for simplification of description, an example in which the phase of the first mixed wave is 0° and the phase of the second mixed wave is 180° is shown, the phases may be any as long as the phase of the first mixed wave and the phase of the second mixed wave have an opposite-phase relationship.

Therefore, for example, an example in which the phase of the first mixed wave is 30° and the phase of the second mixed wave is 210° is also possible.

The first balanced/unbalanced circuit 7 splits the first mixed wave outputted from the positive-phase output terminal 4 of the even harmonic mixer 3 into two split signals.

The first balanced/unbalanced circuit 7 outputs a first split signal which is one of the two split signals of the first mixed wave that is in phase with the first mixed wave from the first balanced positive-phase terminal 8 to the first output terminal 14.

In addition, the first balanced/unbalanced circuit 7 outputs a second split signal which is a split signal opposite in phase to the first mixed wave from the first balanced negative-phase terminal 9 to the second output terminal 15.

The second split signal is a signal obtained by shifting, by 180°, the phase of one of the two split signals of the first mixed wave that is not the first split signal, and is a split signal opposite in phase to the first split signal.

A relationship between the phases of signals outputted from the first balanced positive-phase terminal 8 and the first balanced negative-phase terminal 9 of the first balanced/unbalanced circuit 7 is as follows:

| | First balanced positive-phase terminal 8 | | First balanced negative-phase terminal 9 | |
|---|---|---|---|---|
| 2f_{LO} + f_{IF} | 0° | | 180° | |
| 2f_{LO} - f_{IF} | | 0° | | 180° |
| 2f_{LO} | 0° | | 180° | |

The second balanced/unbalanced circuit 11 splits the second mixed wave outputted from the negative-phase output terminal 5 of the even harmonic mixer 3 into two split signals.

The second balanced/unbalanced circuit 11 outputs a third split signal which is one of the two split signals of the second mixed wave that is in phase with the second mixed wave from the second balanced positive-phase terminal 12 to the second output terminal 15.

In addition, the second balanced/unbalanced circuit 11 outputs a fourth split signal which is a split signal opposite in phase to the second mixed wave from the second balanced negative-phase terminal 13 to the first output terminal 14.

The fourth split signal is a signal obtained by shifting, by 180°, the phase of one of the two split signals of the second mixed wave that is not the third split signal, and is a split signal opposite in phase to the third split signal.

A relationship between the phases of signals outputted from the second balanced positive-phase terminal 12 and the second balanced negative-phase terminal 13 of the second balanced/unbalanced circuit 11 is as follows:

| | Second balanced positive-phase terminal 12 | | Second balanced negative-phase terminal 13 | |
|---|---|---|---|---|
| 2f_{LO} + f_{IF} | 180° | | 0° | |
| 2f_{LO} - f_{IF} | | 180° | | 0° |
| 2f_{LO} | 0° | | 180° | |

A signal with a frequency of 2f_{LO} + f_{IF} and a signal with a frequency of 2f_{LO} - f_{IF} which are outputted from the first balanced positive-phase terminal 8 of the first balanced/unbalanced circuit 7 and a signal with a frequency of 2f_{LO} + f_{IF} and a signal with a frequency of 2f_{LO} - f_{IF} which are outputted from the second balanced negative-phase terminal 13 of the second balanced/unbalanced circuit 11 are in-phase signals, both having a phase of 0°.

Therefore, a signal with a frequency of 2f_{LO} + f_{IF} and a phase of 0° and a signal with a frequency of 2f_{LO} - f_{IF} and a phase of 0° are outputted from the first output terminal 14.

In addition, a signal with a frequency of 2f_{LO} + f_{IF} and a signal with a frequency of 2f_{LO} - f_{IF} which are outputted from the first balanced negative-phase terminal 9 of the first balanced/unbalanced circuit 7 and a signal with a frequency of 2f_{LO} + f_{IF} and a signal with a frequency of 2f_{LO} - f_{IF} which are outputted from the second balanced positive-phase terminal 12 of the second balanced/unbalanced circuit 11 are in-phase signals, both having a phase of 180°.

Therefore, a signal with a frequency of 2f_{LO} + f_{IF} and a phase of 180° and a signal with a frequency of 2f_{LO} - f_{IF} and a phase of 180° are outputted from the second output terminal 15.

Hence, differential signals which are different in phase by 180° from each other are outputted from the first output terminal 14 and the second output terminal 15.

A double wave with a frequency of 2f_{LO} outputted from the first balanced positive-phase terminal 8 of the first balanced/unbalanced circuit 7 and a double wave with a frequency of 2f_{LO} outputted from the second balanced negative-phase terminal 13 of the second balanced/unbalanced circuit 11 are opposite-phase signals that are different in phase by 180° from each other.

Hence, the double wave with a frequency of 2f_{LO} outputted from the first balanced positive-phase terminal 8 and the double wave with a frequency of 2f_{LO} outputted from the second balanced negative-phase terminal 13 cancel each other out at the first output terminal 14. Hence, the double waves with a frequency of 2f_{LO} are not outputted from the first output terminal 14.

A double wave with a frequency of 2f_{LO} outputted from the first balanced negative-phase terminal 9 of the first balanced/unbalanced circuit 7 and a double wave with a frequency of 2f_{LO} outputted from the second balanced positive-phase terminal 12 of the second balanced/unbalanced circuit 11 are opposite-phase signals that are different in phase by 180° from each other.

Hence, the double wave with a frequency of 2f_{LO} outputted from the first balanced negative-phase terminal 9 and the double wave with a frequency of 2f_{LO} outputted from the second balanced positive-phase terminal 12 cancel each other out at the second output terminal 15. Hence, the double waves with a frequency of 2f_{LO} are not outputted from the second output terminal 15.

As is clear from the above, according to the first embodiment, there are included a first balanced/unbalanced circuit splitting the first mixed wave outputted from the even harmonic mixer into two split signals, outputting a first split signal to a first output terminal, and outputting a second split signal to a second output terminal, the first split signal being one of the two split signals of the first mixed wave that is in phase with the first mixed wave, and the second split signal being one of the two split signals of the first mixed wave that is opposite in phase to the first mixed wave; and a second balanced/unbalanced circuit splitting the second mixed wave outputted from the even harmonic mixer into two split signals, outputting a third split signal to the second output terminal, and outputting a fourth split signal to the first output terminal, the third split signal being one of the two split signals of the second mixed wave that is in phase with the second mixed wave, and the fourth split signal being one of the two split signals of the second mixed wave that is opposite in phase to the second mixed wave.

By this, an advantageous effect that differential signals can be outputted without causing passage loss associated with removal of unwanted waves is provided.

### Second Embodiment.

The above-described first embodiment shows an example in which the radio frequency mixer includes the first balanced/unbalanced circuit 7 and the second balanced/unbalanced circuit 11.

In a second embodiment, an example will be described in which the first balanced/unbalanced circuit 7 is a first Marchand balun and the second balanced/unbalanced circuit 11 is a second Marchand balun.

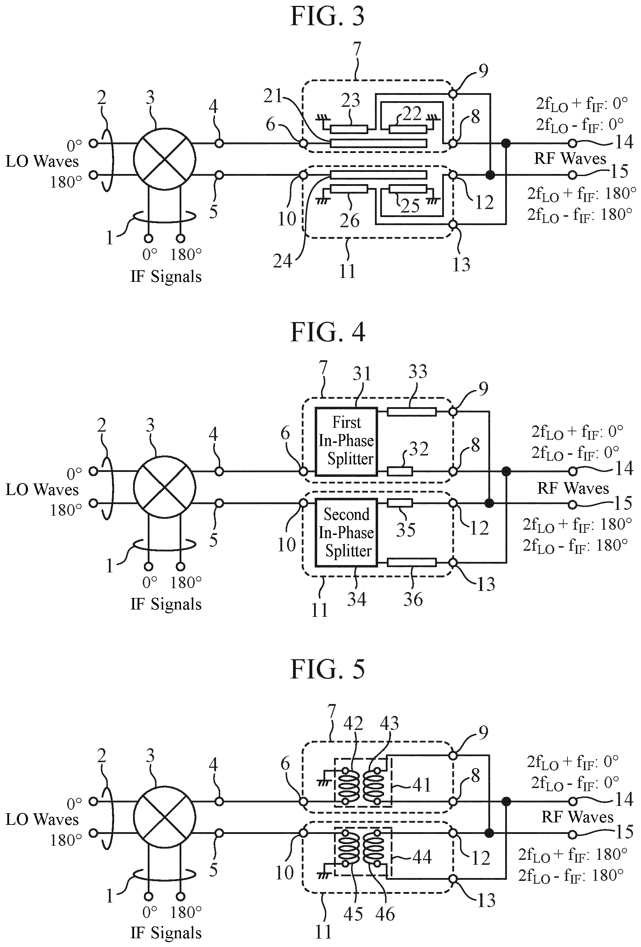

FIG. 3 is a configuration diagram showing a radio frequency mixer of the second embodiment of the invention. In FIG. 3, the same reference signs as those of FIG. 1 indicate the same or corresponding portions and thus description thereof is omitted.

The first balanced/unbalanced circuit 7 which is the first Marchand balun includes transmission lines 21, 22, and 23.

As in the above-described first embodiment, the first balanced/unbalanced circuit 7 which is the first Marchand balun splits a first mixed wave outputted from the even harmonic mixer 3 into two split signals, outputs a first split signal which is one of the two split signals of the first mixed wave that is in phase with the first mixed wave to the first output terminal 14, and outputs a second split signal which is a split signal opposite in phase to the first mixed wave to the second output terminal 15.

The transmission line 21 of the first Marchand balun has one end connected to the first unbalanced terminal 6 and the other end being open, and has a length of one-half wavelength at the frequency 2f_{LO} of double waves.

The transmission line 22 of the first Marchand balun has one end connected to the first balanced positive-phase terminal 8 and the other end being grounded, and is disposed so as to be parallel and adjacent to the transmission line 21.

In addition, the transmission line 22 is a line having a length of one-quarter wavelength at the frequency 2f_{LO} of double waves.

The transmission line 23 of the first Marchand balun has one end connected to the first balanced negative-phase terminal 9 and the other end being grounded, and is disposed so as to be parallel and adjacent to the transmission line 21.

In addition, the transmission line 23 has a length of one-quarter wavelength at the frequency 2f_{LO} of double waves.

The second balanced/unbalanced circuit 11 which is the second Marchand balun includes transmission lines 24, 25, and 26.

As in the above-described first embodiment, the second balanced/unbalanced circuit 11 which is the second Marchand balun splits a second mixed wave outputted from the negative-phase output terminal 5 of the even harmonic mixer 3 into two split signals, outputs a third split signal which is one of the two split signals of the second mixed wave that is in phase with the second mixed wave to the second output terminal 15, and outputs a fourth split signal which is a split signal opposite in phase to the second mixed wave to the first output terminal 14.

The transmission line 24 of the second Marchand balun has one end connected to the second unbalanced terminal 10 and the other end being open, and has a length of one-half wavelength at the frequency 2f_{LO} of double waves.

The transmission line 25 of the second Marchand balun has one end connected to the second balanced positive-phase terminal 12 and the other end being grounded, and is disposed so as to be parallel and adjacent to the transmission line 24.

In addition, the transmission line 25 has a length of one-quarter wavelength at the frequency 2f_{LO} of double waves.

The transmission line 26 of the second Marchand balun has one end connected to the second balanced negative-phase terminal 13 and the other end being grounded, and is disposed so as to be parallel and adjacent to the transmission line 24.

In addition, the transmission line 26 has a length of one-quarter wavelength at the frequency 2f_{LO} of double waves.

The second embodiment differs from the above-described first embodiment in that the first Marchand balun is used as the first balanced/unbalanced circuit 7 and the second Marchand balun is used as the second balanced/unbalanced circuit 11.

The first Marchand balun and the second Marchand balun are known as wideband balanced/unbalanced converting circuits.

Hence, each of the first Marchand balun and the second Marchand balun can also suppress unwanted waves other than double waves of LO waves which are outputted from the even harmonic mixer 3.

For example, LO waves and triple waves with a frequency of 3f_{LO} can also be suppressed.

As is clear from the above, according to the second embodiment, it is configured in such a manner that the first balanced/unbalanced circuit 7 is the first Marchand balun and the second balanced/unbalanced circuit 11 is the second Marchand balun, and thus, unwanted waves other than double waves can be suppressed, in addition to being able to output differential signals without causing passage loss associated with removal of unwanted waves as in the above-described first embodiment.

### Third Embodiment.

In a third embodiment, specific configurations of the first balanced/unbalanced circuit 7 and the second balanced/unbalanced circuit 11 will be described.

FIG. 4 is a configuration diagram showing a radio frequency mixer of the third embodiment of the invention.

In FIG. 4, the same reference signs as those of FIG. 1 indicate the same or corresponding portions and thus description thereof is omitted.

The first balanced/unbalanced circuit 7 includes a first in-phase splitter 31, a first transmission line 32, and a second transmission line 33.

The first in-phase splitter 31 is connected to the first unbalanced terminal 6, and in-phase splits a first mixed wave outputted from the positive-phase output terminal 4 of the even harmonic mixer 3.

The first transmission line 32 is connected at its one end to the first in-phase splitter 31 and connected at its other end to the first balanced positive-phase terminal 8, and allows one of first mixed waves generated by in-phase splitting the first mixed wave by the first in-phase splitter 31 to propagate therethrough.

The second transmission line 33 is connected at its one end to the first in-phase splitter 31 and connected at its other end to the first balanced negative-phase terminal 9, and allows the other one of the first mixed waves generated by in-phase splitting the first mixed wave by the first in-phase splitter 31 to propagate therethrough.

The second transmission line 33 is longer in line length than the first transmission line 32 by a length of one-half wavelength at the frequency 2f_{LO} of double waves.

The second balanced/unbalanced circuit 11 includes a second in-phase splitter 34, a third transmission line 35, and a fourth transmission line 36.

The second in-phase splitter 34 is connected to the second unbalanced terminal 10, and in-phase splits a second mixed wave outputted from the negative-phase output terminal 5 of the even harmonic mixer 3.

The third transmission line 35 is connected at its one end to the second in-phase splitter 34 and connected at its other end to the second balanced positive-phase terminal 12, and allows one of second mixed waves generated by in-phase splitting the second mixed wave by the second in-phase splitter 34 to propagate therethrough.

The fourth transmission line 36 is connected at its one end to the second in-phase splitter 34 and connected at its other end to the second balanced negative-phase terminal 13, and allows the other one of the second mixed waves generated by in-phase splitting the second mixed wave by the second in-phase splitter 34 to propagate therethrough.

The fourth transmission line 36 is longer in line length than the third transmission line 35 by a length of one-half wavelength at the frequency 2f_{LO} of double waves.

The first transmission line 32 and the third transmission line 35 have the same length.

Next, operation will be described.

The first in-phase splitter 31 of the first balanced/unbalanced circuit 7 in-phase splits a first mixed wave outputted from the positive-phase output terminal 4 of the even harmonic mixer 3, outputs one of in-phase split first mixed waves to the first transmission line 32, and outputs the other one of the in-phase split first mixed waves to the second transmission line 33.

The second transmission line 33 of the first balanced/unbalanced circuit 7 is longer in line length than the first transmission line 32 by a length of one-half wavelength at the frequency 2f_{LO} of double waves.

Hence, the phase of signals propagating through the second transmission line 33 and outputted from the first balanced negative-phase terminal 9 is delayed by 180° from that of signals propagating through the first transmission line 32 and outputted from the first balanced positive-phase terminal 8.

The second in-phase splitter 34 of the second balanced/unbalanced circuit 11 in-phase splits a second mixed wave outputted from the negative-phase output terminal 5 of the even harmonic mixer 3, outputs one of the in-phase split second mixed waves to the third transmission line 35, and outputs the other one of the in-phase split second mixed waves to the fourth transmission line 36.

The fourth transmission line 36 of the second balanced/unbalanced circuit 11 is longer in line length than the third transmission line 35 by a length of one-half wavelength at the frequency 2f_{LO} of double waves.

Hence, the phase of signals propagating through the fourth transmission line 36 and outputted from the second balanced negative-phase terminal 13 is delayed by 180° from that of signals propagating through the third transmission line 35 and outputted from the second balanced positive-phase terminal 12.

The phase difference between two first mixed waves outputted from the first in-phase splitter 31 is essentially 0°. However, even if the phase difference between the two first mixed waves is shifted from 0°, by adjusting each of the line lengths of the first transmission line 32 and the second transmission line 33, a phase difference of 180° can be achieved between a signal outputted from the first balanced positive-phase terminal 8 and a signal outputted from the first balanced negative-phase terminal 9.

In addition, the phase difference between two second mixed waves outputted from the second in-phase splitter 34 is essentially 0°. However, even if the phase difference between the two second mixed waves is shifted from 0°, by adjusting each of the line lengths of the third transmission line 35 and the fourth transmission line 36, a phase difference of 180° can be achieved between a signal outputted from the second balanced positive-phase terminal 12 and a signal outputted from the second balanced negative-phase terminal 13.

In the third embodiment, as in the above-described first embodiment, differential signals can be outputted without causing passage loss associated with removal of unwanted waves. The amount of suppression of double waves of LO waves depends on the phase accuracy of the first balanced/unbalanced circuit 7 and the second balanced/unbalanced circuit 11.

### Fourth Embodiment.

In a fourth embodiment, specific configurations of the first balanced/unbalanced circuit 7 and the second balanced/unbalanced circuit 11 will be described.

FIG. 5 is a configuration diagram showing a radio frequency mixer of the fourth embodiment of the invention.

In FIG. 5, the same reference signs as those of FIG. 1 indicate the same or corresponding portions and thus description thereof is omitted.

In the fourth embodiment, the first balanced/unbalanced circuit 7 includes a first transformer 41, and the second balanced/unbalanced circuit 11 includes a second transformer 44.

The first transformer 41 includes a first spiral line 42 and a second spiral line 43.

The first spiral line 42 is a spiral-shaped line having one end connected to the first unbalanced terminal 6 and the other end being grounded.

The second spiral line 43 is a spiral-shaped line having one end connected to the first balanced positive-phase terminal 8 and the other end connected to the first balanced negative-phase terminal 9, and performs electromagnetic induction with the first spiral line 42.

The second transformer 44 includes a third spiral line 45 and a fourth spiral line 46.

The third spiral line 45 is a spiral-shaped line having one end connected to the second unbalanced terminal 10 and the other end being grounded.

The fourth spiral line 46 is a spiral-shaped line having one end connected to the second balanced positive-phase terminal 12 and the other end connected to the second balanced negative-phase terminal 13, and performs electromagnetic induction with the third spiral line 45.

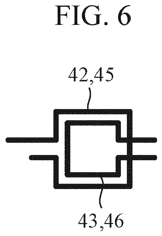

In a radio frequency band, the first transformer 41 is formed by, as shown in FIG. 6, disposing the first spiral line 42 and the second spiral line 43 which are spiral-shaped lines on a dielectric substrate.

The second transformer 44 is also formed by, as shown in FIG. 6, disposing the third spiral line 45 and the fourth spiral line 46 which are spiral-shaped lines on a dielectric substrate.

FIG. 6 is an illustrative diagram showing an example of the first transformer 41 and the second transformer 44.

Although FIG. 6 shows an example in which the number of turns of each of the first transformer 41 and the second transformer 44 is one, by increasing the number of turns, coupling between two spiral lines is improved, enabling the size of the first transformer 41 and the second transformer 44 to be reduced.

In the above-described second and third embodiments, the first balanced/unbalanced circuit 7 and the second balanced/unbalanced circuit 11 include transmission lines, and at least a length of one-half wavelength at the frequency 2f_{LO} of double waves is required. Hence, there is a need to secure an area in which transmission lines with at least a length of one-half wavelength at the frequency 2f_{LO} are mounted.

In the fourth embodiment, the first spiral line 42 and the second spiral line 43 in the first transformer 41 are spiral-shaped lines, and the third spiral line 45 and the fourth spiral line 46 in the second transformer 44 are spiral-shaped lines. Hence, the mounting area can be made smaller than that of the above-described second and third embodiments.

In addition, in the fourth embodiment, as in the above-described first embodiment, differential signals can be outputted without causing passage loss associated with removal of unwanted waves.

Note that in the invention of the present application, a free combination of the embodiments, modifications to any component of the embodiments, or omissions of any component in the embodiments are possible within the scope of the invention.

### INDUSTRIAL APPLICABILITY

The invention is suitable for a radio frequency mixer including an even harmonic mixer that mixes intermediate frequency signals with harmonics having a frequency twice that of local signals.

### REFERENCE SIGNS LIST

1: differential IF terminal, 2: differential LO terminal, 3: even harmonic mixer, 4: positive-phase output terminal, 5: negative-phase output terminal, 6: first unbalanced terminal, 7: first balanced/unbalanced circuit, 8: first balanced positive-phase terminal, 9: first balanced negative-phase terminal, 10: second unbalanced terminal, 11: second balanced/unbalanced circuit, 12: second balanced positive-phase terminal, 13: second balanced negative-phase terminal, 14: first output terminal, 15: second output terminal, 21, 22, 23, 24, 25, 26: transmission line, 31: first in-phase splitter, 32: first transmission line, 33: second transmission line, 34: second in-phase splitter, 35: third transmission line, 36: fourth transmission line, 41: first transformer, 42: first spiral line, 43: second spiral line, 44: second transformer, 45: third spiral line, 46: spiral line.

## Claims

1. A radio frequency mixer comprising:
an even harmonic mixer mixing differential intermediate frequency signals with harmonics having a frequency twice a frequency of differential local signals, and outputting a first mixed wave and a second mixed wave, the first mixed wave being a mixed wave of the intermediate frequency signals and the harmonics, and the second mixed wave being a mixed wave opposite in phase to the first mixed wave;
a first balanced/unbalanced circuit splitting the first mixed wave outputted from the even harmonic mixer into two split signals, outputting a first split signal to a first output terminal, and outputting a second split signal to a second output terminal, the first split signal being one of the two split signals of the first mixed wave that is in phase with the first mixed wave, and the second split signal being one of the two split signals of the first mixed wave that is opposite in phase to the first mixed wave; and
a second balanced/unbalanced circuit splitting the second mixed wave outputted from the even harmonic mixer into two split signals, outputting a third split signal to the second output terminal, and outputting a fourth split signal to the first output terminal, the third split signal being one of the two split signals of the second mixed wave that is in phase with the second mixed wave, and the fourth split signal being one of the two split signals of the second mixed wave that is opposite in phase to the second mixed wave.

2. The radio frequency mixer according to claim 1, wherein
the first balanced/unbalanced circuit is a first Marchand balun, and
the second balanced/unbalanced circuit is a second Marchand balun.

3. The radio frequency mixer according to claim 1, wherein
the first balanced/unbalanced circuit includes:
a first in-phase splitter in-phase splitting the first mixed wave;
a first transmission line connected between the first in-phase splitter and the first output terminal, one of first mixed waves generated by in-phase splitting the first mixed wave by the first in-phase splitter propagating through the first transmission line; and
a second transmission line connected between the first in-phase splitter and the second output terminal, another one of the first mixed waves generated by in-phase splitting the first mixed wave by the first in-phase splitter propagating through the second transmission line,
the second balanced/unbalanced circuit includes:
a second in-phase splitter in-phase splitting the second mixed wave;
a third transmission line connected between the second in-phase splitter and the second output terminal, one of second mixed waves generated by in-phase splitting the second mixed wave by the second in-phase splitter propagating through the third transmission line; and
a fourth transmission line connected between the second in-phase splitter and the first output terminal, another one of the second mixed waves generated by in-phase splitting the second mixed wave by the second in-phase splitter propagating through the fourth transmission line,
a length of the first transmission line is same as a length of the third transmission line,
the second transmission line is longer in line length than the first transmission line by a length of one-half wavelength at the frequency of the harmonics, and
the fourth transmission line is longer in line length than the third transmission line by a length of one-half wavelength at the frequency of the harmonics.

4. The radio frequency mixer according to claim 1, wherein
the first balanced/unbalanced circuit includes:
a first transformer including a first spiral line having one end and another end being grounded, the first mixed wave outputted from the even harmonic mixer being inputted to the one end; and a second spiral line having one end connected to the first output terminal, and another end connected to the second output terminal, the first spiral line and the second spiral line performing electromagnetic induction, and
the second balanced/unbalanced circuit includes:
a second transformer including a third spiral line having one end and another end being grounded, the second mixed wave outputted from the even harmonic mixer being inputted to the one end; and a fourth spiral line having one end connected to the second output terminal, and another end connected to the first output terminal, the third spiral line and the fourth spiral line performing electromagnetic induction.
